# EUROPEAN PATENT APPLICATION

(11) **EP 4 766 126 A1**
(43) Date of publication of application: **24.06.2026**
(21) Application number: 23949151.7
(22) Date of filing: 15.08.2023
(51) Int. Cl.: H10N 60/12, H10N 60/01

(54) **QUANTUM DEVICE AND QUANTUM DEVICE PRODUCTION METHOD**

(71) Applicant: FUJITSU LIMITED, Kawasaki-shi, Kanagawa 211-8588 (JP)
(72) Inventor: SAIDA, Daisuke, Kawasaki-shi, Kanagawa 211-8588 (JP)
(74) Representative: Haseltine Lake Kempner LLP
(86) International application number: PCT/JP2023/029515
(87) International publication number: WO 2025/037381

(57) **Abstract**

A quantum device includes a quantum bit having a Josephson junction element; a signal source connected to the quantum bit; and a resistive element connected between a signal path between the signal source and the quantum bit, and a ground line. The quantum device can be used, for example, in quantum computing.

## Description

### Technical Field

The present disclosure relates to a quantum device and method of manufacturing a quantum device.

### Background Art

As one of the quantum bits used in a quantum computer, a quantum bit having a Josephson junction element is known.

### Citation List

### Patent Literature

Patent Document 1: Japanese National Publication of International Patent Application No. 2018-513580
Patent Document 2: Japanese National Publication of International Patent Application No. 2007-516610
Patent Document 3: U.S. Patent Application Publication No. 2019/0081629

### Summary of Invention

### Technical Problem

Higher accuracy is desired for the operation of a quantum bit.

An object of the present disclosure is to provide a quantum device capable of improving the accuracy of the operation of a quantum bit, and a method of manufacturing the quantum device.

### Solution to Problem

According to one aspect of the present disclosure, there is provided a quantum device including a quantum bit having a Josephson junction element; a signal source connected to the quantum bit; and a resistive element connected between a signal path between the signal source and the quantum bit, and a ground line.

### Advantageous Effects of Invention

According to the present disclosure, the accuracy of the operation of the quantum bit can be improved.

### Brief Description of Drawings

[FIG. 1] FIG. 1 is a circuit diagram illustrating a model used in a simulation.
[FIG. 2] FIG. 2 is a diagram illustrating the result of the first simulation.
[FIG. 3] FIG. 3 is a diagram (part 1) illustrating a result of a second simulation.
[FIG. 4] FIG. 4 is a diagram (part 2) illustrating a result of a second simulation.
[FIG. 5] FIG. 5 is a diagram illustrating a quantum device according to a first embodiment.
[FIG. 6] FIG. 6 is a diagram illustrating a quantum device according to a second embodiment.
[FIG. 7] FIG. 7 is a diagram illustrating a quantum device according to a third embodiment.
[FIG. 8] FIG. 8 is a diagram illustrating a quantum device according to a fourth embodiment.
[FIG. 9] FIG. 9 is a diagram illustrating a quantum device according to a fifth embodiment.
[FIG. 10] FIG. 10 is a schematic diagram (part 1) illustrating a method of forming a quantum bit substrate according to the fifth embodiment.
[FIG. 11] FIG. 11 is a schematic diagram (part 2) illustrating a method of forming a quantum bit substrate according to the fifth embodiment.
[FIG. 12] FIG. 12 is a schematic diagram (part 3) illustrating a method of forming a quantum bit substrate according to the fifth embodiment.
[FIG. 13] FIG. 13 is a schematic diagram (part 4) illustrating a method of forming a quantum bit substrate according to the fifth embodiment.
[FIG. 14] FIG. 14 is a schematic diagram (part 5) illustrating a method of forming a quantum bit substrate according to the fifth embodiment.
[FIG. 15] FIG. 15 is a schematic diagram (part 6) illustrating a method of forming a quantum bit substrate according to the fifth embodiment.
[FIG. 16] FIG. 16 is a schematic diagram illustrating a quantum bit substrate according to a modification of the fifth embodiment.

### Description of Embodiments

Hereinafter, embodiments of the present disclosure will be specifically described with reference to the accompanying drawings. Note that in the present specification and the drawings, components having substantially the same functional configuration may be given the same reference numerals, thereby omitting redundant descriptions.

### (Basic Principle of the Present Disclosure)

First, the basic principle of the present disclosure will be described. It is known that a Josephson junction element behaves as a nonlinear inductor. Therefore, the inventor of the present invention considered modeling of a quantum bit having a Josephson junction element so that the quantum bit can be handled in a superconducting circuit simulator while regarding the Josephson junction element as a nonlinear inductor. In this modeling, the behavior of a quantum bit when a signal having a resonance frequency is given from outside, such as during gate operation, was examined. At that time, as a signal having a resonance frequency, a signal in which a perturbation occurs while the quantum bit remains in the ground state, rather than transitioning to an excited state, was assumed. By using such a signal, a model in which an internal current flows with a current smaller than the zero-point oscillation at the ground level, has a resonance frequency, and becomes zero when averaged over time can be obtained. For example, when this model is applied to a transmon, which is one of the gate type quantum bits, the quantum bit remains at the bottom of the ground level, which guarantees the condition satisfying the transmon region in the simulation. Moreover, when a signal having a resonance frequency is given, the change occurring in the quantum bit and the change occurring in the system coupled with the quantum bit can be observed as the internal current of the circuit using a superconducting circuit simulator. In this way, by regarding the Josephson junction as a nonlinear inductor and including capacitors and so on in the equivalent circuit of the quantum bit, the quantum bit can be handled in the superconducting circuit simulator.

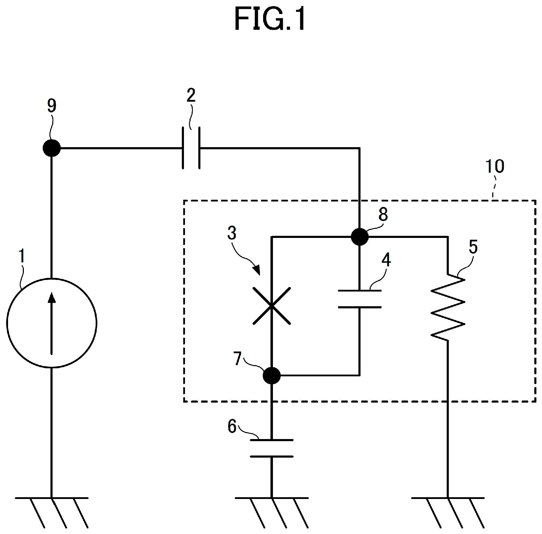

Further, in a quantum device in which two quantum bits are capacitively coupled to each other, an inductance exists in a line for capacitive coupling. Therefore, the inventor of the present invention has adopted a model in which there is a resistance between an end portion of a line serving as a release end for capacitive coupling and the ground while taking the inductance of the line into consideration. For example, for a transmon, a model in which a Josephson junction element, a capacitor, and a resistive element are connected in parallel has been adopted. FIG. 1 is a circuit diagram illustrating a model used for simulation.

As illustrated in FIG. 1, this model has a signal source 1, a capacitor 2, a Josephson junction element 3, a capacitor 4, a resistive element 5, and a capacitor 6. The quantum bit 10 includes the Josephson junction element 3, the capacitor 4, and the resistive element 5. The Josephson junction element 3 and the capacitor 4 are connected in parallel with each other; and the capacitor 6 is connected between one node 7 of the Josephson junction element 3 and the capacitor 4, and the ground. The resistive element 5 is connected between the other node 8 of the Josephson junction element 3 and the capacitor 4, and the ground. The signal source 1 is connected between the node 9 and the ground, and the capacitor 2 is connected between the node 8 and the node 9. The capacitance of the capacitor 6 corresponds to the capacitance between the quantum bit 10 and the ground.

As a result of the simulation performed by the inventor of the present invention by using the model illustrated in FIG. 1, the effect of the capacitor constituting the quantum bit, the effect of the critical current of the Josephson junction element, and the effect of the coupling between the quantum bits could be quantitatively estimated by calculation using a circuit simulator. It was also clarified that the signal supplied from the signal source is easily and accurately applied to the state of the quantum bit by connecting the resistive element to the quantum bit in parallel.

Here, two examples of simulations performed by the inventor of the present invention will be described.

### (First Simulation)

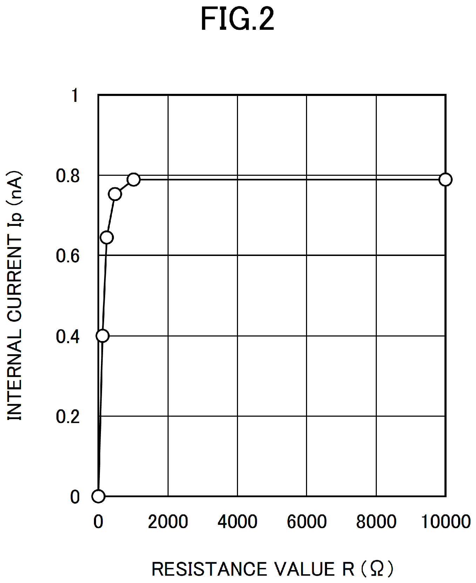

In the first simulation, the relationship between the resistance value of the resistive element 5 and the current flowing inside the quantum bit 10 (internal current) was calculated. The result is illustrated in FIG. 2. As illustrated in FIG. 2, a result was obtained that the internal current Ip is stabilized when the resistance value R of the resistive element 5 is 1000 Ω or more.

### (Second Simulation)

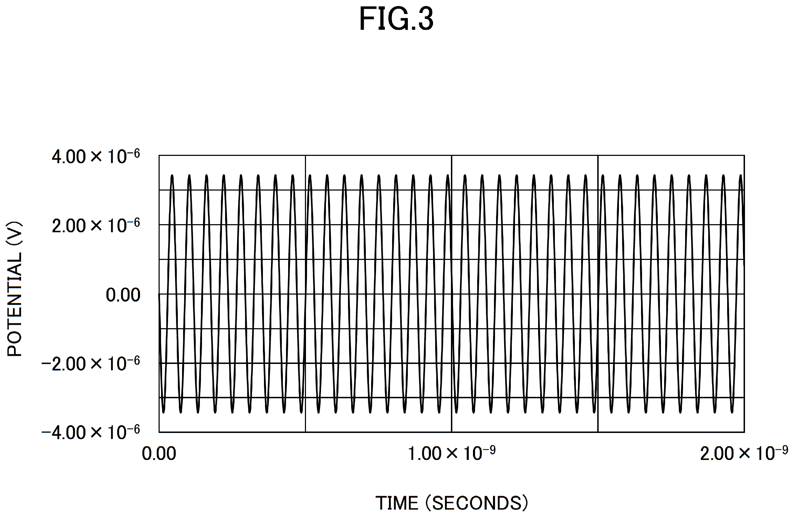

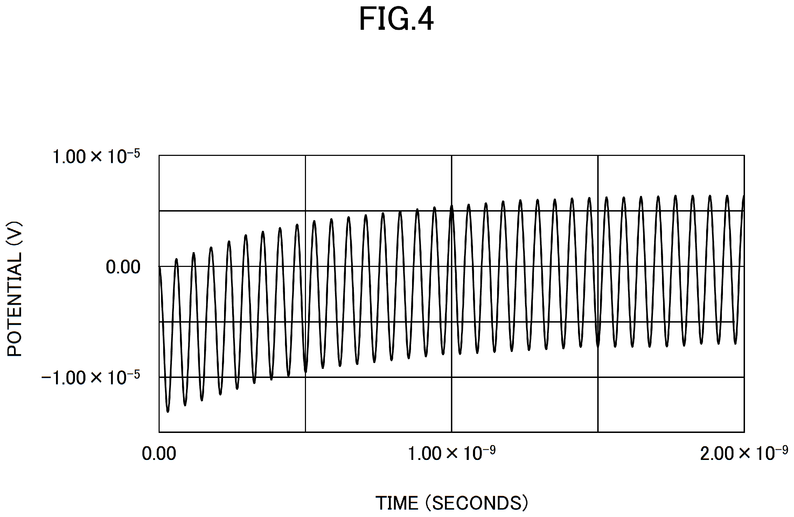

In the second simulation, the change in the potential of the node 8 when the resistance value of the resistive element 5 is 100 Ω or 1000 Ω was calculated. The results are illustrated in FIGS. 3 and 4. FIG. 3 illustrates the change in the potential of the node 8 when the resistance value of the resistive element 5 is 100 Ω, and FIG. 4 illustrates the change in the potential of the node 8 when the resistance value of the resistive element 5 is 1000 Ω. As illustrated in FIGS. 3 and 4, when the resistance value of the resistive element 5 is 100 Ω, a result was obtained that the waveform is stabilized early.

Based on the results of these simulations, the inventor of the present invention came up with the following various configurations in which the resistive elements are actually connected to the quantum bit in parallel.

### (First Embodiment)

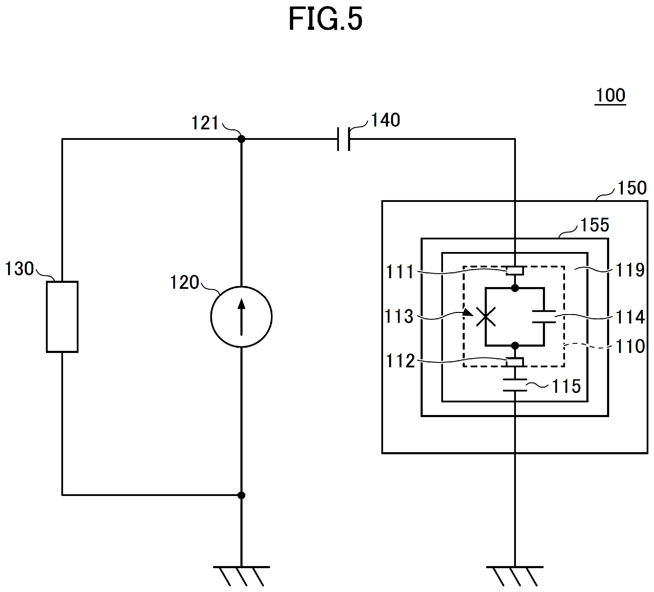

First, a first embodiment will be described. The first embodiment relates to a quantum device. FIG. 5 is a diagram illustrating a quantum device according to the first embodiment.

As illustrated in FIG. 5, a quantum device 100 according to the first embodiment includes a quantum bit substrate 119, a signal source 120, a resistive element 130, a capacitor 140, a dilution refrigerator 150, and a sample holder 155. The quantum bit substrate 119 includes a quantum bit 110 and a capacitor 115. The quantum bit 110 includes a first electrode 111, a second electrode 112, and a Josephson junction element 113. The Josephson junction element 113 is provided between the first electrode 111 and the second electrode 112, and is connected to the first electrode 111 and the second electrode 112. The first electrode 111 and the second electrode 112 are electrically insulated from each other, and a capacitor 114 exists between the first electrode 111 and the second electrode 112. The capacitor 115 is connected between the second electrode 112 and the ground wire.

The quantum bit substrate 119 is supported by a sample holder 155. That is, the sample holder 155 supports the quantum bit 110. The sample holder 155, for example, pinches the quantum bit substrate 119 from above and below to block the influence of an electromagnetic field from the outside to the quantum bit 110. The sample holder 155 may be provided with a contact probe such as a pogo pin. The contact probe can be used for inputting and outputting signals to and from the quantum bit 110. The sample holder 155 is an example of a holder.

The dilution refrigerator 150 accommodates the sample holder 155 and cools the quantum bit 110 to a cryogenic temperature. The dilution refrigerator 150 cools the quantum bit 110 to a temperature of approximately 10 mK, for example.

The signal source 120, the resistive element 130, and the capacitor 140 are provided outside the dilution refrigerator 150. The capacitor 140 is connected between the signal source 120 and the first electrode 111, and the signal source 120 is capacitively coupled to the first electrode 111 via the capacitor 140. The resistive element 130 is connected between a signal path between the signal source 120 and the quantum bit 110, and a ground line. More specifically, the resistive element 130 is connected between a node 121 between the capacitor 140 and the signal source 120, and a ground line. An electrical control signal is supplied from the signal source 120 to the first electrode 111. The resistance value of the resistive element 130 is not limited, and may be, for example, 100 Ω or more to 1000 Ω or less, or 1000 Ω or more to 10,000 Ω or less.

In the first embodiment, the resistive element 130 is connected between a signal path between the signal source 120 and the quantum bit 110, and a ground line. As a result, as was apparent from the simulation by the inventor of the present invention, the signal supplied from the signal source 120 is easily applied accurately to the state of the quantum bit 110, and the accuracy of the operation of the quantum bit 110 can be improved. That is, the fidelity of the state of the quantum bit 110 can be improved.

Further, because the resistive element 130 is provided outside the dilution refrigerator 150, it is possible to suppress the influence of the thermal noise caused by the temperature rise of the resistive element 130 on the state of the quantum bit 110. For example, if there is a time lag between the timing of operating the state of the quantum bit 110 and the timing of completing the cooling of the heat generated in the resistive element 130, the operation of the quantum bit 110 may be inhibited by the thermal noise, but the inhibition of the operation of the quantum bit 110 can be suppressed.

### (Second Embodiment)

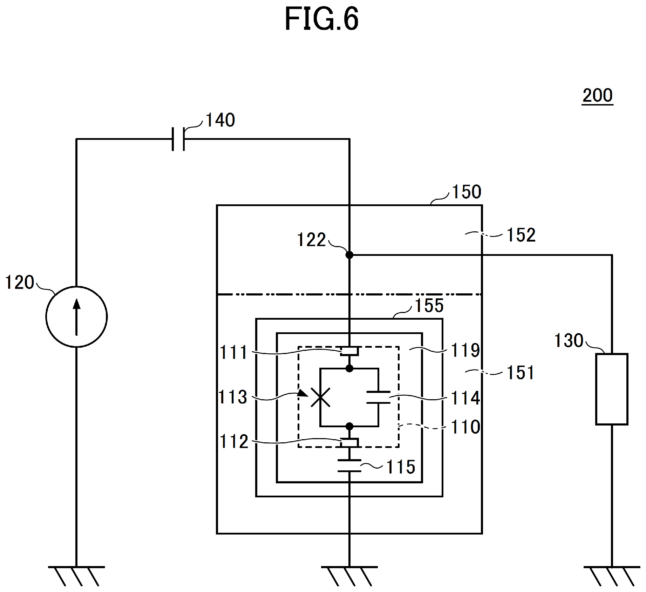

Next, a second embodiment will be described. The second embodiment differs from the first embodiment mainly in the connection of the resistive element. FIG. 6 is a diagram illustrating a quantum device according to the second embodiment.

As illustrated in FIG. 6, in the quantum device 200 according to the second embodiment, the dilution refrigerator 150 has a first temperature region 151 and a second temperature region 152. The first temperature region 151 is a region cooled to a temperature of 100 mK or less, preferably 20 mK or less, and more preferably 10 mK or less, the second temperature region 152 is a region cooled to a temperature of 100 mK or less, and the second temperature region 152 is a region cooled to a temperature higher than the temperature of the first temperature region 151. The resistive element 130 is connected to a node 122 between the capacitor 140 and the first electrode 111. The node 122 is in the second temperature region 152. The sample holder 155 is housed in the first temperature region 151.

Other configurations of the second embodiment are the same as those of the first embodiment.

According to the second embodiment, the signal supplied from the signal source 120 is easily applied accurately to the state of the quantum bit 110, and the accuracy of the operation of the quantum bit 110 can be improved. That is, the fidelity of the state of the quantum bit 110 can be improved. Further, because the resistive element 130 is provided outside the dilution refrigerator 150, the influence of the thermal noise caused by the temperature rise of the resistive element 130 on the state of the quantum bit 110 can be suppressed.

### (Third Embodiment)

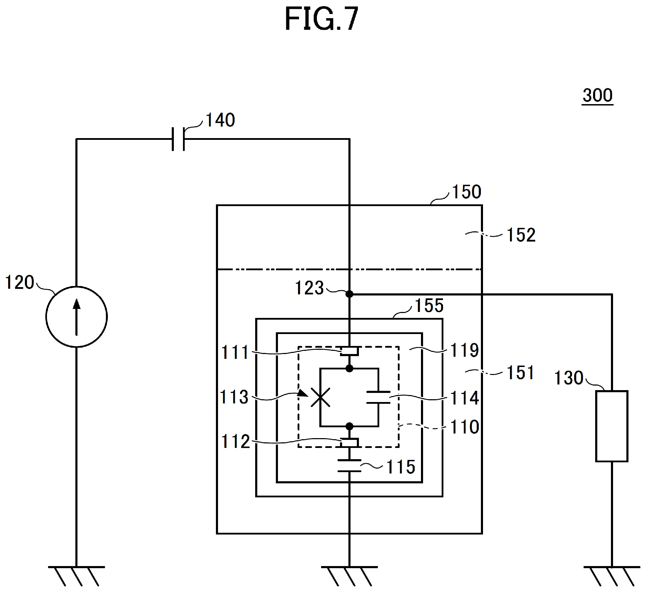

Next, a third embodiment will be described. The third embodiment differs from the second embodiment mainly in the connection of the resistive element. FIG. 7 is a diagram illustrating a quantum device according to the third embodiment.

As illustrated in FIG. 7, in the quantum device 300 according to the third embodiment, the dilution refrigerator 150 has a first temperature region 151 and a second temperature region 152. The resistive element 130 is connected to a node 123 between the capacitor 140 and the first electrode 111. The node 123 is in the first temperature region 151.

Other configurations of the third embodiment are the same as those of the second embodiment.

Also according to the third embodiment, the signal supplied from the signal source 120 is easily applied accurately to the state of the quantum bit 110, and the accuracy of the operation of the quantum bit 110 can be improved. That is, the fidelity of the state of the quantum bit 110 can be improved. Further, because the resistive element 130 is provided outside the dilution refrigerator 150, the influence of the thermal noise caused by the temperature rise of the resistive element 130 on the state of the quantum bit 110 can be suppressed.

### (Fourth Embodiment)

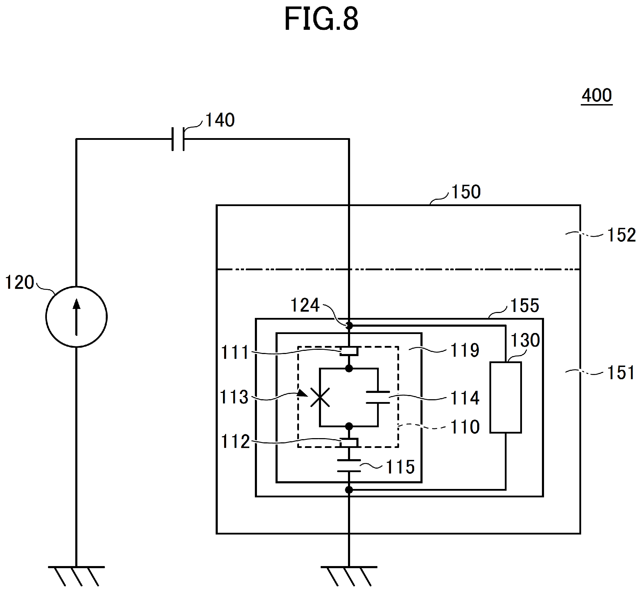

Next, a fourth embodiment will be described. The fourth embodiment differs from the third embodiment mainly in the connection of the resistive element. FIG. 8 is a diagram illustrating a quantum device according to the fourth embodiment.

As illustrated in FIG. 8, in the quantum device 400 according to the fourth embodiment, the dilution refrigerator 150 has a first temperature region 151 and a second temperature region 152. The resistive element 130 is housed in the dilution refrigerator 150, and the dilution refrigerator 150 cools the quantum bit 110 and the resistive element 130. The resistive element 130 is supported by the sample holder 155. That is, the sample holder 155 supports the quantum bit 110 and the resistive element 130. The resistive element 130 is connected to a node 124 between the capacitor 140 and the first electrode 111 in the sample holder 155. Therefore, the quantum bit 110 and the resistive element 130 are cooled to the same temperature in the dilution refrigerator 150.

Other configurations of the fourth embodiment are the same as those of the third embodiment.

According to the fourth embodiment as well, the signal supplied from the signal source 120 is easily applied accurately to the state of the quantum bit 110, and the accuracy of the operation of the quantum bit 110 can be improved. That is, the fidelity of the state of the quantum bit 110 can be improved. Further, because the resistive element 130 is supported by the sample holder 155, the resistive element 130 can be cooled together with the quantum bit 110.

The resistive element 130 may be accommodated in the second temperature region 152. That is, the quantum bit 110 may be cooled to a temperature lower than that of the resistive element 130 in the dilution refrigerator 150. Further, the resistive element 130 may be provided away from the sample holder 155 in the dilution refrigerator 150.

### (Fifth Embodiment)

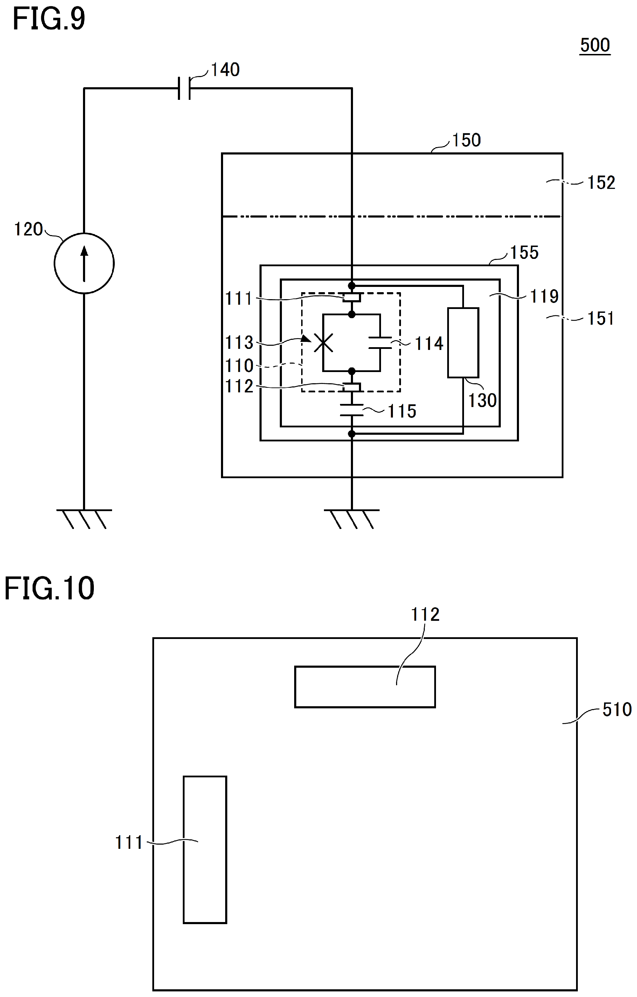

Next, a fifth embodiment will be described. The fifth embodiment differs from the fourth embodiment mainly in the connection of the resistive element. FIG. 9 is a diagram illustrating a quantum device according to the fifth embodiment.

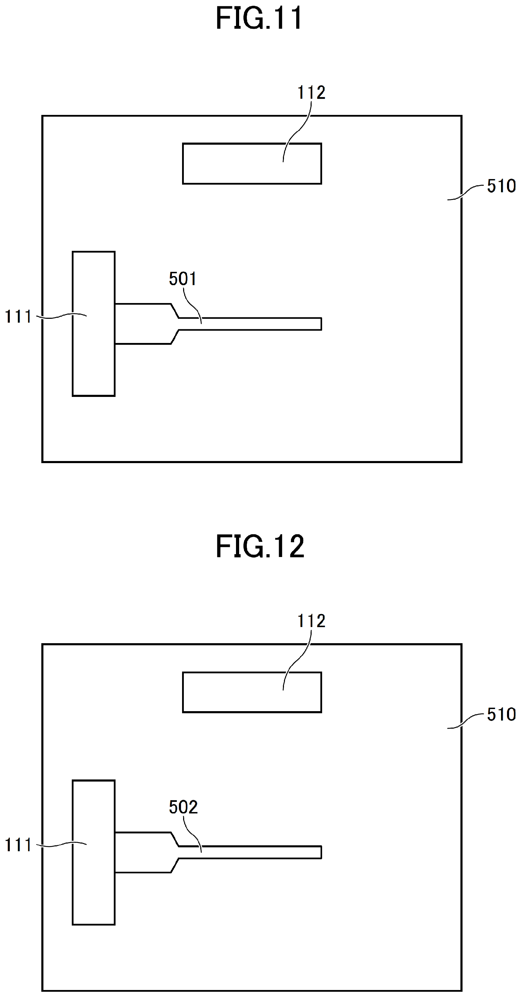

As illustrated in FIG. 9, in the quantum device 500 according to the fifth embodiment, the dilution refrigerator 150 has a first temperature region 151 and a second temperature region 152. The resistive element 130 is provided on the quantum bit substrate 119 together with the quantum bit 110. That is, the quantum bit substrate 119 has the quantum bit 110, the resistive element 130, and the capacitor 115. The resistive element 130 is connected to a first superconductor film 501 (see FIG. 11) connected to the first electrode 111 in the quantum bit substrate 119. The first superconductor film 501 constitutes the Josephson junction element 113. Therefore, also in the fifth embodiment, the quantum bit 110 and the resistive element 130 are cooled to the same temperature in the dilution refrigerator 150.

Now, a method of forming the quantum bit substrate 119 in the fifth embodiment will be described. FIGS. 10 to 15 are schematic diagrams illustrating a method of forming the quantum bit substrate 119 in the fifth embodiment.

First, as illustrated in FIG. 10, a first electrode 111 and a second electrode 112 are formed on a substrate 510 such as a silicon substrate. In the formation of the first electrode 111 and the second electrode 112, for example, a titanium nitride (TiN) film or a niobium (Nb) film is formed and patterned by dry etching.

Next, as illustrated in FIG. 11, a first superconductor film 501 connected to the first electrode 111 is formed. In the formation of the first superconductor film 501, an aluminum (Al) film is obliquely shadow deposited by using a mask.

Then, as illustrated in FIG. 12, the surface of the first superconductor film 501 is oxidized to form an insulating film 502 on the surface of the first superconductor film 501. The insulating film 502 is, for example, an aluminum oxide film. At this time, a conductive portion is left in the first superconductor film 501 without being oxidized.

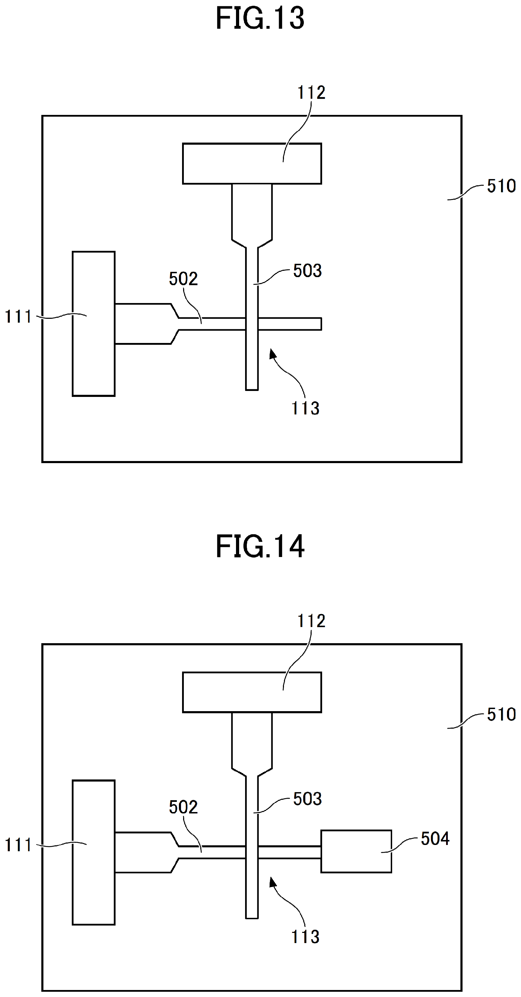

Subsequently, as illustrated in FIG. 13, a second superconductor film 503 connected to the second electrode 112 is formed. The second superconductor film 503 is formed so that a portion thereof is positioned on the insulating film 502. In the formation of the second superconductor film 503, oblique shadow deposition of an aluminum film by using a mask is performed. The first superconductor film 501 and the second superconductor film 503 can be formed by using the same mask by changing the method of oblique shadow deposition. The Josephson junction element 113 is constituted of the first superconductor film 501, the insulating film 502, and the second superconductor film 503 overlapped with each other. After the formation of the second superconductor film 503, the masks used for the formation of the first superconductor film 501 and the second superconductor film 503 are removed. The material of the first superconductor film 501 and the material of the second superconductor film 503 are also deposited on the masks, but the deposits are removed together with the removal of the masks. That is, lift-off is performed.

Next, as illustrated in FIG. 14, an aluminum film 504 connected to the first superconductor film 501 is formed. The aluminum film 504 is formed with a thickness so that the entire aluminum film is oxidized by natural oxidation. In the formation of the aluminum film 504, the aluminum film is evaporated by using a mask, and then the mask is removed. The aluminum film is an example of a metal film.

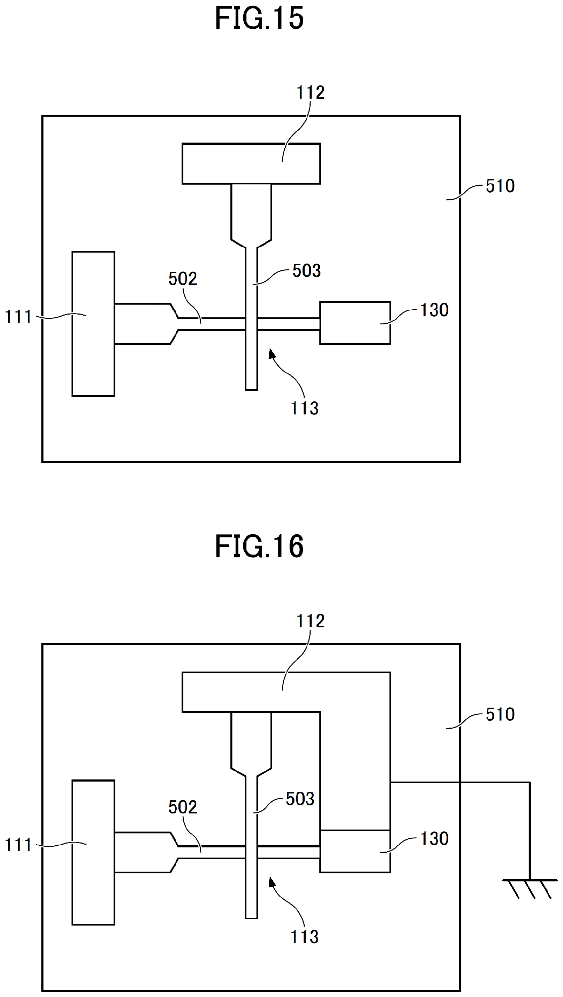

Thereafter, as illustrated in FIG. 15, the entire aluminum film 504 is oxidized by natural oxidation to form the resistive element 130. Then, the resistive element 130 and the ground electrode portion are connected by wire bonding.

Thus, the quantum bit substrate 119 according to the fifth embodiment can be formed.

As illustrated in FIG. 16, the second electrode 112 may be formed in contact with the resistive element 130, and the second electrode 112 may be grounded. In this case, the quantum bit substrate 119 does not need to have the capacitor 115.

The quantum device according to the present disclosure can be used for quantum computing, for example.

Although the preferred embodiments and the like have been described in detail, the present disclosure is not limited to the above-described embodiments and the like, and various modifications and substitutions may be made to the above-described embodiments and the like without departing from the scope of the claims.

### Reference Signs List

100, 200, 300, 400, 500: quantum device
110: quantum bit
111: first electrode
112: second electrode
113: Josephson junction element
114, 115, 140: capacitors
119: quantum bit substrate
120: signal source
130: resistive element
150: dilution refrigerator
151: first temperature region
152: second temperature region
155: sample holder
501: first superconductor film
502: insulating film
503: second superconductor film
504: aluminum film
510: substrate

## Claims

1. A quantum device comprising:
a quantum bit having a Josephson junction element;
a signal source connected to the quantum bit; and
a resistive element connected between a signal path between the signal source and the quantum bit, and a ground line.

2. The quantum device according to claim 1, further comprising:
a dilution refrigerator configured to cool the quantum bit and the resistive element.

3. The quantum device according to claim 2, wherein the quantum bit and the resistive element are cooled to a same temperature in the dilution refrigerator.

4. The quantum device according to claim 3, further comprising:
a holder configured to support the quantum bit and the resistive element.

5. The quantum device according to claim 3, further comprising:
a holder configured to support the quantum bit, wherein
the resistive element is provided away from the holder.

6. The quantum device according to claim 2, wherein the quantum bit is cooled to a lower temperature than the resistive element in the dilution refrigerator.

7. The quantum device according to claim 6, further comprising:
a capacitor provided in the signal path, wherein
the resistive element is connected between a portion of the signal path between the capacitor and the signal source, and the ground line.

8. The quantum device according to claim 1, further comprising:
a dilution refrigerator configured to cool the quantum bit, wherein
the resistive element is provided outside the dilution refrigerator.

9. The quantum device according to any one of claim 1 to 8, wherein the resistive element has a resistance value of 100 Ω or more and 1000 Ω or less.

10. The quantum device according to any one of claim 1 to 8, the resistive element has a resistance value of 1000 Ω or more and 10000 Ω or less.

11. A method of manufacturing a quantum device, the method comprising:
forming, on a substrate, a Josephson junction element including a first superconductor film, a second superconductor film, and an insulating film between the first superconductor film and the second superconductor film;
forming, on the substrate, a metal film electrically connected to the first superconductor film; and
oxidizing the entire metal film to form a resistive element.

12. The method of manufacturing a quantum device according to claim 11, wherein the metal film is an aluminum film.
